(19) Europäisches Patentamt / European Patent Office / Office européen des brevets

(11) **EP 2 156 476 B1**

(12) **EUROPEAN PATENT SPECIFICATION**

(45) Date of publication and mention
of the grant of the patent:
**30.03.2016 Bulletin 2016/13**

(21) Application number: **08761218.0**

(22) Date of filing: **19.06.2008**

(51) Int Cl.:
***H01L 31/048*** (2006.01)

(86) International application number:
**PCT/EP2008/057783**

(87) International publication number:
**WO 2008/155383 (24.12.2008 Gazette 2008/52)**

(54) **SOLAR CELL DEVICE, METHOD FOR PRODUCING AND USE**

SOLARZELLENANORDNUNG, VERFAHREN ZUR HERSTELLUNG UND VERWENDUNG

DISPOSITIF DE CELLULE SOLAIRE, PROCÉDÉ DE PRODUCTION ET UTILISATION

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **21.06.2007 EP 07110791**

(43) Date of publication of application:
**24.02.2010 Bulletin 2010/08**

(73) Proprietor: **Saint-Gobain Glass France S.A.
92400 Courbevoie (FR)**

(72) Inventor: **KARG, Franz
81671 Muenchen (DE)**

(74) Representative: **Gebauer, Dieter Edmund
Splanemann
Patentanwälte Partnerschaft
Rumfordstraße 7
80469 München (DE)**

(56) References cited:
**DE-A1- 19 526 733    JP-A- 2001 308 360
US-A- 5 725 006    US-A- 5 782 994
US-A1- 2001 047 819**

**Description**

Field of the invention

The present invention relates to a solar cell device and a method for producing such a solar cell device, and to an information board comprising such a solar cell device and its use, in particular for displaying information such as advertisements, street numbers, emergency exit directions, and the like.

Background of the invention

Information boards and signs for street numbers, names, emergency exits or general information boards often are located at a distance from the power supply mains, resulting in high costs for additional electric lines for such information boards. Additionally, for example emergency exit signs require additional fail-proof secondary power supplies, such as a battery, thereby causing further costs.

For reducing the cost of manufacturing and mounting illuminated information boards, photovoltaically powered illumination systems have been developed in the past. For example, commercially available photovoltaically powered street numbers equipped with conventional backlit diffusing screens supplied with opaque letters and numbers are known. The power supply of the illumination is realized by a battery charged during daytime by solar cells. Due to aesthetic reasons, the area of the solar cell is minimized and for an optimized irradiation with light the solar cell is tilted out of the vertical orientation and is separated from the illumination unit.

DE 195 26 733 describes a conventional silicon solar cell with a patterned antireflection layer.

US 5 725 006 discloses examples of solar battery modules for displaying a desired pattern. The surface of a single crystalline or polycrystalline power generation layer is modified so as to change the reflecting direction of incident light in a preselected surface area in order to produce the desired pattern when observed from a selected direction.

US 5 782 994 describes a solar cell module with a front surface side covering material comprising a patterned surface region forming a display pattern, and an adjacent further surface region having a different surface pattern.

EP 1 291 834 A1 describes a photovoltaically powered information board. In the described information board the solar module is separated from the information display area.

DE 42 30 726 A1 describes a solar street sign composed of a solar panel and a transparent plate mounted thereon illuminated by a linear light source. Due to the opaque information on the transparent plate significant shadowing effects occur on the photovoltaic layer resulting in a considerable drop of the electrical power output of the solar panel.

A further drawback of a solar street sign according to the prior art is its operation by night or in a dark environment. It is known that in planar waveguides with a constant and positive difference of the refractive index between the waveguide and the surrounding materials, waves are guided without loss. Consequently, no light coupled laterally in the transparent plate acting as the waveguide with opaque information printed on its surface is scattered out of the surface of the transparent plate resulting in a bad viewing contrast for a viewer of the street sign. There is a need for an improved solar cell device, especially one that is well suited to act as an information board.

Summary of the Invention

In accordance with the invention there is provided a solar cell device comprising a photovoltaically active layer between a transparent front cover and a back cover, wherein the front cover comprises a first surface region and a second surface region opposite thereto and facing the photovoltaically active layer, and the back cover comprises a third surface region facing the photovoltaically active layer (1) and a fourth surface region opposite thereto, wherein at least one of the first to the fourth surface regions is provided with a first area and a second area, which areas (6,6a) have different light modulation properties, wherein both areas are light transparent, and wherein the solar cell device further comprises at least one light source (7) for coupling light laterally into at least one of the front cover (2) and the back cover (3).

The present invention provides a significantly simplified, cost-effective, and space-saving configuration of a solar cell device comprising a solar cell module usable in an information board. In the present invention the available surface area on the solar cell device itself is utilized for displaying information in one or both of the front cover and back cover. To this end, the front cover and/or back cover have a first area with first light modulation properties and a second area with second, different light modulation properties. The expression different light modulation properties is used to refer to a difference in optical properties that causes a contrast to the viewer in passive viewing conditions under ambient light conditions and/or when viewing under illumination conditions where light is transmitted through the viewed surface. The different light modulation properties can e.g. be different reflection properties, different light refraction properties, and/or different light scattering properties. The first area containing the information to be displayed still is light transparent, i.e. has a non-zero light transmittance, and the second area is also light transparent. The advantage thereof is that entire surface area of the photovoltaically active layer, including the first area used for information display, is usable for generation of electrical energy. The transparency of the first area can be somewhat different than that of the second area.

In a typical solar cell device such as a solar module, a photovoltaically active layer is arranged in an integrated functional unit between a front cover and a back cover, to generate electrical energy when optical radiation (light) is irradiated on the solar module. The front and back cover can be made of any suitable material used for solar cell modules, e.g. glass, plastic, etc. For example, the front cover can be a glass superstrate and the back cover a glass substrate, as known in the field of solar cell technology. Equally, it is possible to use foil material for one or both of the front and back cover.

The solar cell device of the present invention can be used as a device for on the one hand collecting energy and on the other hand displaying information. In this way, a given area, e.g. on the side or roof of a building, can be used for both purposes at the same time. There is no need that the collecting of energy stands in relationship or is coupled with the displaying of information, e.g. the display can be passive and thereby only visible during the day, and the electrical energy can be supplied to an external load or to a grid. Moreover, the solar cell device is fitted with an illumination for displaying the information in the darkness. At least a part of the energy collected by the solar cell device during light hours can preferably be used for powering the illumination, e.g. via a rechargeable battery.

The invention also provides a method for producing a solar cell device, comprising the steps of arranging a photovoltaically active layer between a front cover and a back cover, wherein the front cover comprises a first surface region and a second surface region opposite thereto and facing the photovoltaically active layer, and the back cover comprises a third surface region facing the photovoltaically active layer and a fourth surface region opposite thereto; and treating at least one of the first to the fourth surface regions before, during or after arranging of the photovoltaically active layer so as to provide at least a first area that provides light modulation properties different from a second area; and providing at least one light source (7) for coupling light laterally into at least one of the front cover (2) and the back cover (3). By the treating step, the information to be displayed is marked on the respective surface region(s).

The invention moreover provides an information board comprising a solar cell device of the invention, and a method of displaying information by the use of the solar cell device.

A basic configuration for an information board according to an embodiment of the present invention comprises a solar module, an energy storage unit (e.g. battery or accumulator) arranged to be charged by the solar module under ambient light conditions, an illumination unit for operation by night or in a dark environment, and possible further elements such as a dimming switch or an optional proximity and/or motion switch. Thereby, the front side (such as - for instance - a glass front cover) or the back side (such as a glass back cover or polymer back sheet) of the solar module itself shall be used as a surface for displaying information such as letters, numbers, advertisements, and the like. Depending on the orientation of the marked plate relative to the illumination, the marking should be conducted preferably on the front side of the solar cell device, e.g. for mounting on a wall, or on the back side of the solar cell device, e.g. for mounting in front of a window. Thereby, the marking is made up by areas on the front cover and/or the back cover of the solar cell module providing light modulation properties different from light modulation properties of surrounding areas.

Brief Description of Figures

For a better understanding of the invention and to show how the same may be put to practice, reference will now be made, by'way of example, to the accompanying drawings in which:

Figs. 1A to 1D show different shadowing effects a thin film solar module may be subject to;
Fig. 2 shows a cross-sectional view of a solar cell device according to a first embodiment;
Fig. 3 shows a cross-sectional view of a solar cell device according to a second embodiment;
Fig. 4 shows a cross-sectional view of a solar cell device according to a third embodiment;
Fig. 5 and Fig. 6 show a cross-sectional view of a solar cell device according to a fourth embodiment of the present invention;
Fig. 7 shows a cross-sectional view of a solar cell device according to a fifth embodiment;
Fig. 8 shows a top view of a solar cell device according to an embodiment of the present invention during operation in daytime, schematically showing the viewing contrast for a viewer; and
Fig. 9 shows a.top view of a solar cell device according to an embodiment of the present invention during operation in nighttime, schematically showing the viewing contrast for a viewer.

Detailed Description of the Invention

Now a description will be given of solar cell devices according to embodiments of the present invention that may be used as information boards, where the information to be displayed is provided on the front cover 2 and/or on the back cover 3 of the solar cell module in the form of first areas 6 providing light modulation properties different from one or more second areas, e.g. their surroundings.

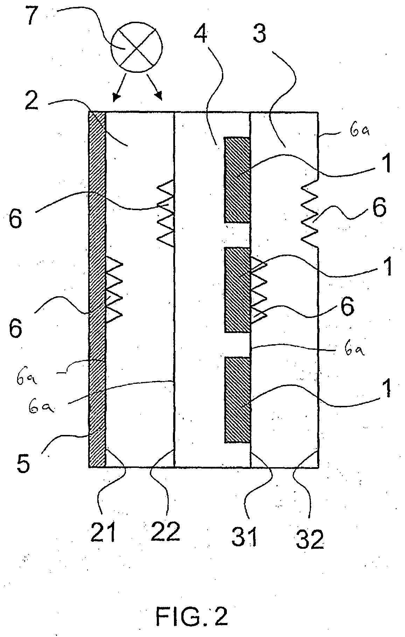

According to a first embodiment of the present invention shown in Fig. 2, a solar cell device is provided in the form of a solar cell module with a photovoltaically active layer 1 embedded between a transparent front cover 2 and a back cover 3.

The photovoltaically active layer in the present invention can be formed of a sequence of layers, such as various electrode and intermediate layers in addition to a photosensitive semiconductor layer. In particular the photovoltaically active layer typically includes a front electrode layer facing the front cover 2, and a back electrode layer facing the back cover 3, with the photosensitive semiconductor layer arranged between the front and back electrode layers. The photovoltaically active layer can be a solar cell or solar cell layer.

The front cover 2 comprises a first surface region 21 and a second surface region 22 opposite to the first surface region and facing the photovoltaically active layer 1, and the back cover 3 comprises a third surface region 31 facing the photovoltaically active layer 1 and a fourth surface region 32 opposite to the third surface region, whereby at least one of the first to the fourth surface regions, i.e. region 21, 22, 31, and/or 32, comprises a first area 6 that exhibits light modulation properties different from a second area 6a, e.g. the surroundings. Thus, information may be written into one or both of the front cover 2 (the cover at the side facing an external light source or the sun during normal operation and through which at least the majority of light is received for generation of electrical energy) and the back cover 3 of the solar cell module.

The different light modulation properties can e.g. be different reflection properties and/or different light scattering properties. Suitably, the first area containing the information to be displayed still is light transmittant. The advantage thereof is that the surface area of the photovoltaically active layer covered by the first area is usable for generation of electrical energy.

The front cover 2 of almost all solar modules is made of glass or a transparent plastic. Also the backside cover 3 of the solar module may consist of glass or at least partially of a transparent plastic. Furthermore, the front cover 2 and/or the back cover 3 or at least a transparent outer layer of a back cover 3 of the solar module can be used as a dielectric waveguide for light coupled into the front cover 2 and/or the back cover 3 laterally at an edge of the respective transparent plate or film. This fact may preferably be used for operation by night or in a dark environment for illuminating the information to be displayed in an efficient way. According to a preferred embodiment, the solar cell device comprises a light source 7.

Information to be displayed can be perceived clearly in a bright environment and in a dark environment. The optical properties of the front cover 2 and the back cover 3 of the solar module are complementary for an illumination from the outside (e.g. during daytime) and an illumination by an electric light source 7 coupled in laterally into the front cover 2 or the back cover 3 (e.g. during the night). For example a light source is arranged at one or more positions along the circumference of the front or back cover, so that it shines into the narrow lateral edge of the transparent front and/or back cover. The light source can for example be a lamp of any kind, or an outlet of a waveguide from a lamp arranged at some distance.

In the example of Fig. 2, a photovoltaically active layer 1 is embedded in a transparent embedding layer 4. The embedding layer 4 is in contact with the photovoltaically active part 1, the front cover 2 and/or the back cover 3. The first surface 21 and/or second surface 22 of the front cover 2 may provide at least a first area 6 providing light modulation properties different from the light modulation properties of their respective surroundings. Furthermore, the third surface 31 and/or fourth surface 32 of the back cover 3 may provide at least a first area 6 providing light modulation properties different from the light modulation properties of their respective surroundings. The front cover 2 and/or the back cover 3 may optionally be covered with a covering layer 5 exhibiting for example dirt repelling properties (not shown for the back cover 3). To retain the light scattering at the first area 6 the refractive index of the covering layer 5 is suitably lower than the refractive index of the front cover 2 in case of marking the front cover and/or must exhibit a lower refractive index than the refractive index of the back cover 3 in case of a marking of the back cover.

During operation at daytime or operation under the irradiation of an external light source, light is transmitted through the covering layer 5, the front cover 2, and in some cases the embedding layer 4 onto the photovoltaically active layer 1 in case of an irradiation from the front side. In the case of an additional irradiation from the backside (through the back cover 3) light is transmitted,through the optional covering layer 5 and through a transparent back cover 3 onto the photovoltaically active layer 1. Between back cover 3 and photovoltaically active layer 1 there may be an additional embedding layer 4.

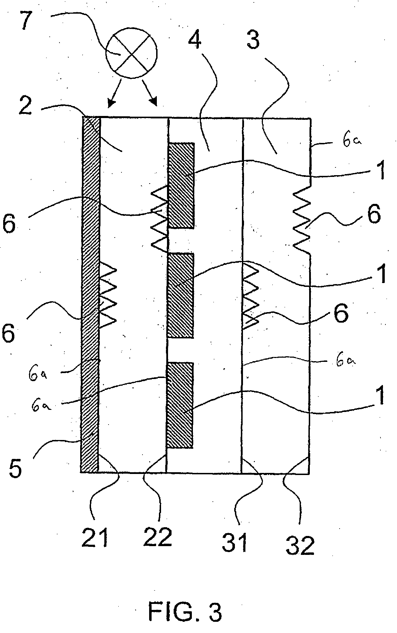

Fig. 3 shows another embodiment of the present invention. The arrangement of the solar cell device shown in Fig. 3 is identical to the arrangement of the solar cell device shown in Fig. 2 with the exception that the photovoltaically active layer 1 is in contact with the front cover 2. In Fig. 2 the photovoltaically active layer 1 is in contact with the back cover 3.

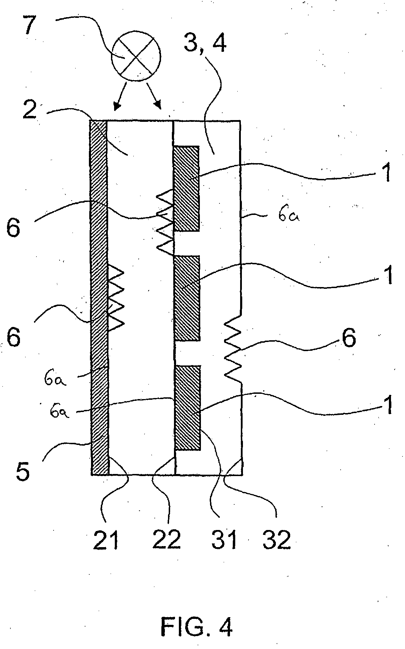

Fig. 4 shows yet another embodiment of the present invention. In the arrangement of the solar cell device shown in Fig. 4 the photovoltaically active layer 1 is in contact with the front cover 2 and the back cover 3 of the solar module is at the same time the embedding layer 4. The surface region 31 is formed by the interface between the embedding layer 4 and the rear side of the photovoltaically active layer 1. The remaining arrangement of the solar cell device shown in Fig. 4 is identical to the arrangement of the solar cell device shown in Fig. 2.

In case of information markings 6 are being placed on the front cover 2 (for example in the case of mounting the solar cell device according to an embodiment of the present invention on a wall) shadowing effects caused by first areas 6 provided on the first surface 21 or on the second surface 22 onto the photovoltaically active layer 1 have to be considered.

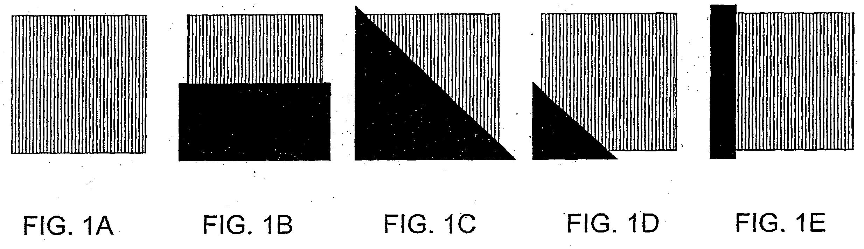

Figs. 1A to 1E show by way of example different shadowing effects on thin film solar modules. Thin film solar modules are typically composed of elongated cells extending over the whole length of the solar panel. In thin film solar cells the photovoltaically active layer is a thin film of typically less than 100 $\mu$m thickness. A suitable type of thin-film solar cells are for example based on a group I-III-VI semiconductor, also referred to as a chalkopyrite semiconductor. Such a semiconductor is generally of the copper indium diselenide ("CIS") type, wherein this expression is to be understood such that indium can be partly or fully replaced by gallium and/or aluminium, and selenium can be partly or fully replaced by sulphur. CIS type solar cells are for example described in J. Palm, V. Probst and F. H. Karg, "Second generation CIS solar modules" Solar Energy, vol. 77, p. 757-765, 2004. Thin-film solar cells comprise a thin film of a photosensitive semiconductor layer, typically between thin front and back electrode layers, and suitably further thin layers such as buffer layers.

Table 1 corresponding to Figs. 1A to 1E shows the electric power output (in percent of an unshaded module) of a thin film solar module subject to the different shadowing effects.

Table 1: electrical power output of a thin film solar module subject to different shadowing effects

| shadowing effects | without Fig. 1A | 50% vertical Fig. 1B | 50% diagonal Fig. 1C | 12,5% diagonal Fig. 1D | two cells Fig. 1D |
|---|---|---|---|---|---|
| $P_{out}$ % | 100% | 50% | 10% | 80% | 66% |

It was found that the form of the solitary cells of a module and the position and size of the shadowing effect by the information to be displayed relative to the solitary cells is important for the functionality of the solar module and should preferably be taken into account. In a tessellated arrangement of nearly quadratic cells larger effects on power output at relatively low shadowing can be found. A thin-film solar module composed of narrow cells was found to perform relatively robust under partial shadowing conditions.

With respect to Figs. 1A to 1E in combination with Table 1 it can be seen that partial shadowing effects can lead to significant drops of the performance of the solar module. This would e.g. lead to a lower charging of a battery electrically coupled to the solar module. Preferably, the marking 6 of the front cover of a solar cell device of the invention should be arranged such that the electrical power output of the solar module does not drop lower than 50 percent, and more preferably the electrical power output of the solar module should not drop lower than 75 percent of a solar cell device having no markings 6.

The overall electrical power output of the solar module depends predominantly on the shadowing effects on a solitary cell being part of a series connected string of cells forming the solar module. To ensure 50 percent (75 percent) of the original electrical power output of the solar module after applying the markings 6 for information to be displayed on the front cover 2 the fraction of shadowed cell area on a solitary cell may at most be 50 percent (25 percent) in the extreme case of opaque information on the front cover. In case the markings 6 reduce the light intensity arriving at the photovoltaically active layer 1 only by 50 percent, the fraction of the marking area 6 relative to the total cell area - at least partially shadowing a single cell may be 100 percent (50 percent). According to an embodiment of the present invention, the following design specification is preferably applied:

$$(1-T) \times C_{rel} \leq 0.5 , \qquad (1)$$

more preferably

$$(1-T) \times C_{rel} \leq 0.25 \qquad (2)$$

where T ($0 < T \leq 1$) is the relative light transmittance through the first area with respect to the second area (6a), and $C_{rel}$ ($0 \leq C_{rel} \leq 1$) is, amongst the individual cells of the module, the maximum fraction of the active cell surface area that is covered with the first region. In other words, $C_{rel}$ denotes the relative geometric coverage such as expressed by the ratio of cell area covered with marked area 6 to total cell area of that cell of the solar module that has the maximum shadowing. Preferably the first area (marked area) 6 is not opaque, i.e. has a non-zero light transmittance. Light transmittance of an area of an object is defined as the fraction of incident light intensity that passes through that area, so for the first areas absolute light transmittance $T_1$ can be represented as $T_1=I_1/I_0$, with the incident light intensity $I_0$ and transmitted light intensity $I_1$. Analogously the transmittance of the second areas can be defined as $T_2=I_2/I_0$. It is useful to consider the relative transmittance of the first and second areas $T=T_1/T_2$. Suitably the relative light transmittance $T$ is at least 0.05, preferably at least 0.1, more preferably at least 0.25, even more preferably at least 0.5, most preferably at least 0.75, such as at least 0.9. In this way only a relatively small or even neglectible diminishing of electrical power output is caused by the information displayed. Suitably the light transmittance $T_2$ of the second areas is at least 0.75, preferably at least 0.9, most preferably at least 0.95.

The practical limitations for the graphical design of the information to be displayed according to this ancillary condition are low for typical thin film solar modules. Typically these modules exhibit narrow long solitary cells (typically in a format of

0.5 cm x 100 cm). An advantage of thin-film solar devices is that they typically have a uniform appearance, on the light facing surface there are typically only thin structuring lines visible, so that they provide a suitable background for displaying of information. According to a preferred embodiment, a solar cell device comprising thin film solar cells is used.

Contrary to the limitation according to the above described design rule for information to be displayed on the front cover 2 of the solar cell module, information on the back cover 3 of the solar cell module can be configured in any suitable way. For example, if an information board using a solar cell device according to the present invention is mounted in front of a window and information to be displayed is written into the back cover 3 of the solar module, the photovoltaically active layer 1 is irradiated through the front cover 2 so that there will be no shading effects of the information to be displayed on the photovoltaically active layer 1. Suitably in this case the back cover is provided with a source of illumination, which is preferably at least partly supplied with electrical energy from the solar cell device.

For the operation of an information board using a solar cell device according to the present invention in darkness (for example during night or in a not illuminated room) at least one light source 7 is provided for coupling light laterally into the front cover 2 and/or the back cover 3. The light of the light source 7 coupled into the front cover 2 or the back cover 3 is guided through the front cover 2 and the back cover 3 respectively acting as planar waveguides as described above. When the light coupled into the front cover 2 and the back cover 3 respectively interacts with a first area 6 provided on one or more of the first to the fourth surfaces 21, 22, 31, 32 then the light is scattered or diffracted out of the front cover 2 and the back cover 3 respectively. Consequently, information to be displayed being provided on the front cover 2 and the back cover 3 respectively and being composed of first areas 6 appears lighter than their surrounding areas. Thus, using a somewhat different mechanism than during daytime, contrast between the same first and second areas is efficiently generated.

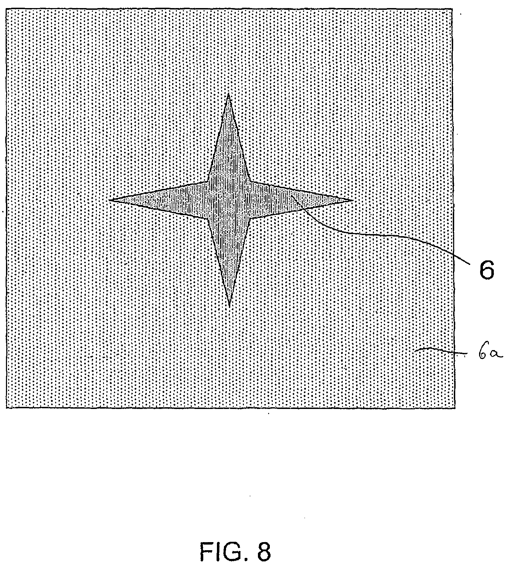

Fig. 8 shows a top view of a solar cell device according to the present invention during operation at daytime or under ambient lighting conditions, schematically showing the view contrast for a viewer. The information to be displayed in this example is composed of first areas 6 that have been provided with different light modulation properties by sand-blasting the outer surface 21 of the front cover. The first areas 6a appear darker than the surrounding areas 6a.

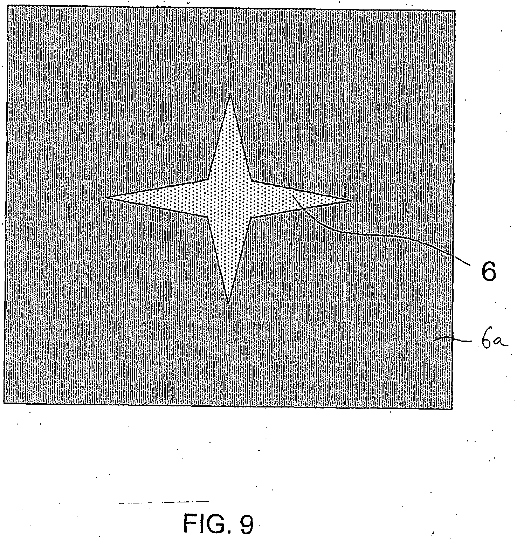

Fig. 9 shows an embodiment of the information board of Figure 8, adapted for in operation in a dark environment (for example during night), wherein light is laterally guided into the front cover and scattered out from the rough surface at the first area 6. Information to be displayed and being composed of first areas 6 appears brighter than its surrounding areas.

REALIZATION OF THE LIGHT MODULATION PROPERTIES OF THE FIRST AREA 6

The light modulating properties of the first area 6 can be realized by roughening the first area. Thereby, the first area 6 exhibits a different roughness compared to the roughness of its surroundings. Different roughness causes different light scattering properties, and can also cause different light reflection properties. As a result, a contrast between roughened first area 6 and second area 6a is seen by the viewer in ambient light conditions. During operation at night or in darkness, when light is coupled into the front and/or back cover, the roughened areas preferentially scatter light out of the cover plate, also causing a contrast.

The roughening of the first area can be realized for example by sand blasting the first area 6 or by chemical etching of the first area 6.

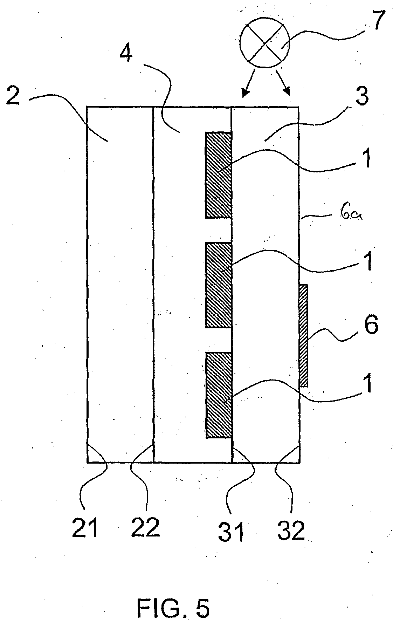

Another way of realizing the light modulating properties of the first area 6 is to change the refractive index of the respective first area 6. By changing the light refraction properties in this way, also a difference in light reflection properties between first and second areas is obtained. This change of the refractive index of the first area 6 can be realized by deposition of at least one thin layer with a different, in particular lower refractive index compared to the refractive index of the front cover 2 and/or back cover 3. Fig. 5 shows a solar cell device according to an embodiment of the present invention where a thin transparent layer exhibiting a lower refractive index than the refractive index of the back cover 3 is deposited on the back cover 3.

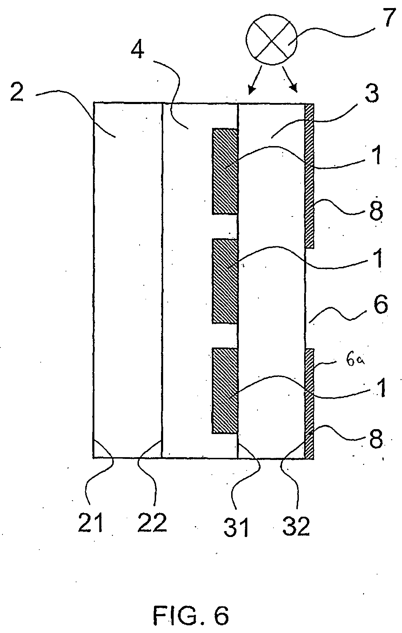

An alternative change of the light modulation properties of the first area 6 can be realized by first coating the complete front or back cover with a higher refractive index material (as compared to the bulk index of the front or back cover material) and by subsequently removing this thin transparent layer 8 in the area of the markings 6. Fig. 6 shows a solar cell device according to an embodiment of the present invention where a thin layer 8 exhibiting a higher refractive index than the refractive index of the back cover 3 is deposited on the back cover 3 and a part of the thin layer 8 is removed so as to provide a first area 6 exhibiting a lower refractive index compared to its surroundings.

Another way of realizing a change of the refractive index of the first area 6 of the surface of the front cover 2 and/or the back cover 3 can be by ion exchange processes. Further, another way of realizing a change of the refractive index of the first area 6 of the surface of the front cover 2 and/or the back cover 3 can be by etching the first area 6 of the front cover 2 and/or the back cover 3.

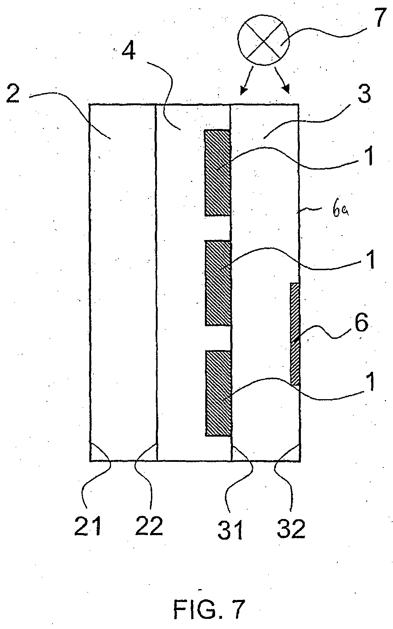

Fig. 7 shows a solar cell device according to an embodiment of the present invention where the refractive index of a part of the back cover 3 is reduced either by ion exchange processes or by etching of the respective first area 6.

When a layer with lower refractive index is arranged in the first areas 6 as discussed hereinabove, a suitable contrast also for application at night with lateral coupling of light into the front (or back) cover is provided. The cover serves as dielectric waveguide. A dielectric waveguide carries the more modes the larger the difference in refraction coefficient with its surroundings is. When the difference diminishes along the waveguide, such as at the first surface area with lower refractive index, the "superfluous modes" are coupled out of the waveguide, which is visible as lighter areas on the surface.

According to an embodiment of the present invention a rechargeable battery can be arranged to be charged by the photovoltaically active layer 1. Furthermore, a proximity or motion switch can be arranged to switch on/off the light source 7 for saving energy during the operation of a solar cell device used as an information board in a dark environment.

It shall be clear that when reference is made in the description and in the claims to the information to be displayed by the first areas, this can be a positive or a negative representation of the information. The choice can depend on the desired contrast, and on the total shadowing that is obtained.

A solar cell device according to an embodiment of the present invention exhibits a plurality of advantages compared to prior art solar cell devices. Namely, during operation of a solar cell device according to the present invention in a bright environment shadowing effects of information to be displayed being provided on the front cover 2 or the back cover 3 onto the photovoltaically active layer 1 may be reduced to a minimum whereby the electrical power output of the solar module is better than in prior art solar cell modules.

A further advantage of a solar cell device according to an embodiment of the present invention compared to prior art solar cell devices is the operation of the solar cell module in a dark environment. By providing first areas 6 on the front cover 2 or the back cover 3 exhibiting different light modulation properties compared to their surroundings light generated by a light source 7 coupled into the front cover 2 or the back cover 3 is scattered or diffracted out of the front cover 2 or the back cover 3 whereby a good viewing contrast is provided for the viewer of an information board using the solar cell device according to the present invention.

Yet another advantage of a solar cell device according to the present invention is the reduced number of components of its assembly. By arranging the markings 6 directly onto the front cover 2 or the back cover 3 of the solar module an additional transparent plate for providing information to be displayed, as e.g. used in DE 42 30 726 A1, is dispensable. In other words, while the prior art envisioned adding a separate information carrier to a'solar cell module, embodiments of the present invention modify the solar cell module itself, in order to carry and display information.

It is also to be noted, that besides those already mentioned above, many modifications and variations of the above embodiments may be made without departing from the novel and advantageous features of the present invention defined within the scope of the appended claims.

**Claims**

1. A solar cell device comprising a photovoltaically active layer (1) between a transparent front cover (2) and a back cover (3), wherein the front cover (2) comprises a first surface region (21) and a second surface region (22) opposite thereto and facing the photovoltaically active layer (1), and the back cover (3) comprises a third surface region (31) facing the photovoltaically active layer (1) and a fourth surface region (32) opposite thereto, wherein at least one of the first to the fourth surface regions (21, 22, 31, 32) is provided with a first area (6) and a second area (6a), which areas (6,6a) have different light modulation properties, wherein both areas are light transparent, and wherein the solar cell device further comprises at least one light source (7) for coupling light laterally into at least one of the front cover (2) and the back cover (3).

2. The solar cell device according to claim 1, wherein the first and second areas (6,6a) have different light reflection properties.

3. The solar cell device according to claim 1 or 2, wherein the first and second areas (6,6a) have different light scattering properties.

4. The solar cell device according to any one of claims 1-3, wherein the first area (6) and the second area (6a) have different roughness or refractive index.

5. The solar cell device according to any one of the preceding claims wherein the photovoltaically active layer (1) is a thin film photovoltaic layer.

6. The solar cell device according to any one of claims 1 to 5, comprising a plurality of series connected solar cells each having an active cell surface area, said first area (6) being arranged such that
$(1-T) \times C_{rel} \leq 0.5$, preferably $(1-T) \times C_{rel} \leq 0.25$,
wherein T is the relative light transmittance through the first area (6) with respect to the second area (6a), and wherein $C_{rel}$ is, among the plurality of cells, the maximum fraction of the active cell surface area that is covered with the first region.

7. A method for producing a solar cell device, comprising the steps of

- arranging a photovoltaically active layer (1) between a front cover (2) and a back cover (3), wherein the front cover (2) comprises a first surface region (21) and a second surface region (22) opposite thereto and facing the photovoltaically active layer (1), and the back cover (3) comprises a third surface region (31) facing the photovoltaically active layer (1) and a fourth surface region (32) opposite thereto;
- treating at least one of the first to the fourth surface regions (21, 22, 31, 32) before, during or after arranging of the photovoltaically active layer so as to provide at least a light transparent first area (6) that provides light modulation properties different from a light transparent second area (6a); and
- providing at least one light source (7) for coupling light laterally into at least one of the front cover (2) and the back cover (3).

8. The method according to claim 7, wherein treating the first area (6) comprises roughening the first area (6), such as by sandblasting or by chemical etching.

9. The method according to claim 7 or 8, wherein the front cover and/or back cover has a bulk refractive index, and wherein treating of the first area (6) comprises depositing a layer with a refractive index different from, in particular lower than, the bulk refractive index of the front cover (2) and/or back cover (3).

10. The method according to claim 7 or 8, wherein the treatment of the first area (6) comprises depositing a surface layer with a refractive index different from, in particular higher than, the bulk refractive index of the front cover (2) and/or back cover (3).

11. The method according to claim 7 or 8, wherein treating comprises at least one of etching or performing an ion exchange processes of the front cover (2) and/or the back cover (3).

12. Information board comprising a solar cell device according to one of the claims 1 to 6.

13. Use of a solar cell device according to any one of claims 1 to 6 for displaying information.


**Patentansprüche**

1. Solarzellvorrichtung mit einer photovoltaisch aktiven Schicht (1) zwischen einer durchsichtigen vorderseitigen Abdeckung (2) und einer rückseitigen Abdeckung (3), wobei die vorderseitige Abdeckung (2) eine erste Oberflächenregion (21) und eine dieser gegenüberliegende zweite Oberflächenregion (22), welche der photovoltaisch aktiven Schicht (1) gegenüberliegt, umfasst, und die rückseitige Abdeckung (3) eine dritte Oberflächenregion (31), die der photovoltaisch aktiven Schicht (1) gegenüberliegt, und eine dieser gegenüberliegende vierte Oberflächenregion (32) umfasst, wobei wenigstens eine aus der ersten bis vierten Oberflächenregion (21,22, 31, 32) mit einem ersten Bereich (6) und einem zweiten Bereich (6a) versehen ist, wobei die Bereiche (6, 6a) verschiedene Lichtmodulationseigenschaften haben, wobei beide Bereiche lichtdurchlässig sind, und wobei die Solarzellvorrichtung weiterhin wenigstens eine Lichtquelle (7) zum seitlichen Einkoppeln von Licht in wenigstens eine aus der vorderseitigen Abdeckung (2) und der rückseitigen Abdeckung (3) umfasst.

2. Solarzellvorrichtung nach Anspruch 1, wobei der erste und zweite Bereich (6, 6a) verschiedene Lichtreflexionseigenschaften haben.

3. Solarzellvorrichtung nach Anspruch 1 oder 2, wobei der erste und zweite Bereich (6, 6a) verschiedene Lichtstreueigenschaften haben.

4. Solarzellvorrichtung nach einem der Ansprüche 1-3, wobei der erste Bereich (6) und der zweite Bereich (6a) eine verschiedene Rauheit oder Brechungsindex haben.

5. Solarzellvorrichtung nach einem der vorherigen Ansprüche, bei welcher die photovoltaisch aktive Schicht (1) eine Dünnfilm-Photovoltaikschicht ist.

6. Solarzellvorrichtung nach einem der Ansprüche 1 bis 5, mit einer Vielzahl von in Reihe verschalteten Solarzellen, die jeweils einen aktiven Zelloberflächenbereich haben, wobei der erste Bereich (6) so angeordnet ist, dass (1-T) x $C_{rel} \leq 0,5$, vorzugsweise (1-T) x $C_{rel} \leq 0,25$ ist, wobei T die relative Lichtdurchlässigkeit durch den ersten Bereich (6) in Bezug auf den zweiten Bereich (6a) ist, und wobei $C_{rel}$, aus der Vielzahl von Zellen, der maximale Anteil des aktiven Zelloberflächenbereichs, der mit der ersten Region bedeckt ist, ist.

7. Verfahren zur Herstellung einer Solarzellvorrichtung, welches die folgenden Schritte umfasst

- Anordnen einer photovoltaisch aktiven Schicht (1) zwischen einer vorderseitigen Abdeckung (2) und einer rückseitigen Abdeckung (3), wobei die vorderseitige Abdeckung (2) eine erste Oberflächenregion (21) und eine dieser gegenüberliegende zweite Oberflächenregion (22), welche der photovoltaisch aktiven Schicht (1) gegenüberliegt, umfasst, und die rückseitige Abdeckung (3) eine dritte Oberflächenregion (31), die der photovoltaisch aktiven Schicht (1) gegenüberliegt, und eine dieser gegenüberliegende vierte Oberflächenregion (32) umfasst;,
- Behandeln wenigstens einer aus der ersten bis vierten Oberflächenregion (21, 22, 31, 32) vor, während oder nach dem Anordnen der photovoltaisch aktiven Schicht so, dass wenigstens ein lichtdurchlässiger erster Bereich (6) bereitgestellt wird, der Lichtmodulationseigenschaften hat, die von einem lichtdurchlässigen zweiten Bereich (6a) verschieden sind; und
- Bereitstellen wenigstens einer Lichtquelle (7) zum seitlichen Einkoppeln von Licht in wenigstens eine aus der vorderseitigen Abdeckung (2) und der rückseitigen Abdeckung (3).

8. Verfahren nach Anspruch 7, bei welchem das Behandeln des ersten Bereichs (6) ein Rauhen des ersten Bereichs (6), beispielsweise durch Sandstrahlen oder chemisches Ätzen, umfasst.

9. Verfahren nach Anspruch 7 oder 8, wobei die vorderseitige Abdeckung und/oder rückseitige Abdeckung einen Massenbrechungsindex aufweist, und wobei das Behandeln des ersten Bereichs (6) das Abscheiden einer Schicht mit einem Brechungsindex, der verschieden ist von, insbesondere kleiner ist als, der Massenbrechungsindex der vorderseitigen Abdeckung (2) und/oder rückseitigen Abdeckung (3), umfasst.

10. Verfahren nach Anspruch 7 oder 8, wobei das Behandeln des ersten Bereichs (6) das Abscheiden einer Oberflächenschicht mit einem Brechungsindex, der verschieden ist von, insbesondere größer ist als, der Massenbrechungsindex der vorderseitigen Abdeckung (2) und/oder rückseitigen Abdeckung (3), umfasst.

11. Verfahren nach Anspruch 7 oder 8, wobei das Behandeln wenigstens eines aus Ätzen oder Durchführen eines Ionenaustauschprozesses der vorderseitigen Abdeckung (2) und/oder der rückseitigen Abdeckung (3) umfasst.

12. Informationstafel mit einer Solarzellvorrichtung nach einem der Ansprüche 1 bis 6.

13. Verwendung einer Solarzellvorrichtung nach einem der Ansprüche 1 bis 6 zum Anzeigen von Information.

**Revendications**

1. Un dispositif de cellules solaires comprenant une couche photovoltaïquement active (1) entre une façade transparente (2) et une façade arrière (3), où la façade avant (2) comprend une première région de surface (21) et une deuxième région de surface (22) opposée s'y rapportant et face à la couche photovoltaïquement active (1) et la façade arrière (3) comprend une troisième région (31) face à la couche photovoltaïquement active (1) et une quatrième région (32) opposée s'y rapportant, où au moins l'une des régions de surface comprises entre la première à la quatrième régions de surface (21, 22, 31, 32) est fournie avec une première région (6) et une deuxième région (6a), lesquels régions (6, 6 a) ayant des propriétés de modulation de lumière différentes, où les deux régions sont transparentes à la lumière, et où le dispositif de cellules solaires comprend en outre au moins une source lumineuse (7) pour coupler la lumière latéralement dans au moins l'une des façades comprises entre la façade avant (2) à la façade arrière (3).

2. Le dispositif de cellules solaires selon la revendication 1, où la première et la deuxième région (6, 6a) présentent des propriétés différentes de réflexion de la lumière.

3. Le dispositif de cellules solaires selon la revendication 1 ou 2, où la première et la deuxième région (6, 6a) présentent des propriétés différentes de diffusion de la lumière.

4. Le dispositif de cellules solaire selon l'une quelconque des revendications 1-3, où la première région (6) et la deuxième région (6a) ont une rugosité différente ou un indice de réfraction différent.

5. Le dispositif de cellule solaire selon l'une quelconque des revendications précédentes où la couche active photovoltaïquement (1) est une couche photovoltaïque à couche mince.

6. Le dispositif de cellules solaires selon l'une quelconque des revendications 1 à 5, comprenant une pluralité de cellules solaires connectées en série, dont chacune présente une surface de cellule active, ladite première région (6) de surface étant disposée de telle manière que $(1-T) \times C_{rel} \leq 0.5$, de préférence $(1-T) \times C_{rel} \leq 0.25$, où T est la transmittance lumineuse à travers la première région (6) relative à la deuxième région (6a), et où $C_{rel}$, parmi la pluralité des cellules, est la fraction maximale de la surface de la cellule active qui est couverte par la première région.

7. Une méthode pour la production d'un dispositif de cellules solaires, comprenant les étapes suivantes

   - la disposition d'une couche photovoltaïquement active (1) entre une façade avant (2) et une façade arrière (3), où la façade avant (2) comprend une première région de surface (21) et une deuxième région de surface (22) opposée s'y rapportant et face à la couche photovoltaïquement active (1) et la façade arrière (3) comprend une troisième région (31) face à la couche photovoltaïquement active (1) de la surface et une quatrième région (32) opposée s'y rapportant,
   - le traitement d'au moins l'une des régions de surface comprises entre la première à la quatrième région de surface (21, 22, 31, 32) avant, pendant ou après la disposition de la couche photovoltaïquement active (1) afin de fournir une première région (6) transparente à la lumière qui fournit des propriétés de modulation lumineuse différentes d'une deuxième région (6a); et
   - fournir au moins une source lumineuse (7) pour coupler de la lumière latéralement dans au moins l'une des façades comprises entre la façade avant (2) à la façade arrière (3).

8. La méthode selon la revendication 7, où le traitement de la première région (6) comprend rendre rugueuse la première région (6), par exemple par le sablage ou la gravure chimique.

9. La méthode selon l'une des revendications 7 ou 8, où la façade avant et/ou la façade arrière a un indice de réfraction de masse, et où le traitement de la première région (6) comprend déposer une couche avec un indice de réfraction différent de, en particulier inférieur à, l'indice de réfraction de masse de la façade avant (2) et/ou la façade arrière (3).

10. La méthode selon l'une des revendications 7 ou 8, où le traitement de la première région (6) comprend déposer d'une couche de surface avec un indice de réfraction différent de, en particulier plus élevé que, l'indice de réfraction de masse de la façade (2) avant et/ou la façade arrière (3).

11. La méthode selon l'une des revendications 7 ou 8, où le traitement comprend au moins un processus compris entre la gravure et l'échange d'ions de la façade avant (2) et/ou la façade arrière (3).

12. Tableau d'affichage d'informations comprenant un dispositif de cellules solaires selon l'une des revendications 1 à 6.

**13.** Utilisation d'un dispositif de cellules solaires selon l'une quelconque des revendications 1 à 6 pour l'affichage des informations.

FIG. 1A        FIG. 1B        FIG. 1C        FIG. 1D        FIG. 1E

FIG. 2

FIG. 3

FIG. 4

FIG. 5

FIG. 6

FIG. 7

FIG. 8

6

6a

FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 19526733
- US 5725006 A
- US 5782994 A
- EP 1291834 A1
- DE 4230726 A1

**Non-patent literature cited in the description**

- **J. PALM ; V. PROBST ; F. H. KARG.** Second generation CIS solar modules. *Solar Energy,* 2004, vol. 77, 757-765